# EUROPEAN PATENT APPLICATION

(11) **EP 4 780 165 A1**
(43) Date of publication of application: **22.07.2026**
(21) Application number: 26152424.3
(22) Date of filing: 16.01.2026
(51) Int. Cl.: H10D 84/05, H03K 17/687, H10D 84/80, H10D 1/47, H10D 30/47, H10D 64/23, H10D 62/85

(54) **CASCODE GAN POWER DEVICE**

(30) Priority: 21.01.2025 CN 202510088556
(71) Applicant: CorEnergy Semiconductor Co.,Ltd, 215600 Zhangjiagang, Suzhou, Jiangsu (CN)
(72) Inventor: WU, Leke, Zhangjiagang City, Suzhou City, 215600 (CN); LI, Yiheng, Zhangjiagang City, Suzhou City, 215600 (CN); ZHU, Tinggang, Zhangjiagang City, Suzhou City, 215600 (CN)
(74) Representative: Alatis

(57) **Abstract**

A cascode GaN power device is provided. The cascode GaN power device includes a GaN device, an Si MOS transistor, and a resistor. A source of the GaN device is connected to a drain of the Si MOS transistor, a gate of the GaN device is connected to a terminal of the resistor, and another terminal of the resistor is connected to a source of the Si MOS transistor. A drain of the GaN device serves as a drain of the cascode GaN power device, a gate of the Si MOS transistor serves as a gate of the cascode GaN power device, and the source of the Si MOS transistor serves as a source of the cascode GaN power device.

## Description

### TECHNICAL FIELD

The present invention relates to the technical field of semiconductors, and in particular to a cascode GaN power device.

### BACKGROUND

The GaN power device, benefiting from excellent properties of the material, has significant advantages in high-temperature, high-voltage, and high-frequency applications. The most significant advantage of the GaN power device is high switching frequency and low switching loss, the former can increase the power density of the module to reduce its volume, while the latter can improve the efficiency of the module.

The GaN power devices are divided into two types: an enhancement mode and a depletion mode. When used in circuits, the enhancement-mode device is required. At present, there are two ways to implement the enhancement-mode GaN power devices. One is a GaN device with a p-GaN structure, which is inherently enhancement-mode. The other is a cascode power device. In the cascode power device, turn-on and turn-off of the GaN device are controlled by an Si Metal Oxide Semiconductor (MOS) transistor, when the Si MOS transistor is turned on, a gate voltage of the GaN device drops rapidly below a threshold voltage, a channel of the GaN device is turned on accordingly, initiating the conduction of the entire cascode power device. When the Si MOS transistor is turned off, the gate voltage of the GaN device exceeds the threshold voltage thereof, the channel of the GaN device is turned off accordingly, initiating the turn-off of the entire cascode power device. The switching of the GaN device is constrained by the turn-on of the Si MOS transistor, making it difficult to control its turn-on time and turn-off time, and resulting in poor Electro Magnetic Interference (EMI) characteristics. Therefore, how to design a cascode GaN power device with a simple structure and capacity to improve EMI characteristics is crucial.

### SUMMARY

An objective of the present invention is to provide a cascode GaN power device, which has a simple structure and capacity to improve EMI characteristics.

To achieve the objective described above, the present invention provides the following solutions.

The present invention provides a cascode GaN power device, including a GaN device, an Si MOS transistor, and a resistor; where
a source of the GaN device is connected to a drain of the Si MOS transistor, a gate of the GaN device is connected to a terminal of the resistor, and another terminal of the resistor is connected to a source of the Si MOS transistor; and a drain of the GaN device serves as a drain of the cascode GaN power device, a gate of the Si MOS transistor serves as a gate of the cascode GaN power device, and the source of the Si MOS transistor serves as a source of the cascode GaN power device.

In some embodiments, the GaN device includes a substrate, the source, the gate, the drain, a passivation layer, and an epitaxial structure; and the epitaxial structure includes a GaN buffer layer, a GaN channel layer and an AlGaN barrier layer epitaxially grown sequentially from bottom to top on the substrate;
an end of the passivation layer is provided with a source groove, wherein the source groove extends downward from a top surface at the end of the passivation layer into the GaN channel layer, and the source is arranged in the source groove and connected to a two-dimensional free electron gas formed inside the GaN channel layer;
another end of the passivation layer is provided with a drain groove, wherein the drain groove extends downward from a top surface at the another end of the passivation layer into the GaN channel layer, and the drain is arranged in the drain groove and connected to the two-dimensional free electron gas formed inside the GaN channel layer; and
the gate is arranged on the top surface of the passivation layer, close to the source, and spaced from the source.

In some embodiments, the GaN device is a depletion-mode GaN device.

In some embodiments, the passivation layer is formed by depositing SiO₂, SiN or Al₂O₃ by employing a Plasma Enhance Chemical Vapor Deposition (PECVD), Low Pressure Chemical Vapor Deposition (LPCVD), or Atomic Layer Deposition (ALD) method.

In some embodiments, the resistor is composed of the two-dimensional free electron gas formed inside the GaN channel layer.

In some embodiments, a resistance value of the resistor is 8 ohms.

In some embodiments, the cascode GaN power device further includes a resistor electrode;
the resistor electrode is arranged on the GaN device, the resistor is connected to the resistor electrode, and the resistor electrode is connected to the source of the Si MOS transistor.

In some embodiments, the source, the gate and the drain are all fabricated by using a semiconductor process.

In some embodiments, the semiconductor process includes lithography, sputtering, and etching.

In some embodiments, the epitaxial structure is formed by carrying out epitaxial growth in a Metal-organic Chemical Vapor Deposition (MOCVD) equipment.

According to specific embodiments of the present invention, the present invention has the following technical effects.

The present invention provides a cascode GaN power device, which includes a GaN device, an Si MOS transistor, and a resistor. A source of the GaN device is connected to a drain of the Si MOS transistor, a gate of the GaN device is connected to a terminal of the resistor, and another terminal of the resistor is connected to a source of the Si MOS transistor. A drain of the GaN device serves as a drain of the cascode GaN power device, a gate of the Si MOS transistor serves as a gate of the cascode GaN power device, and the source of the Si MOS transistor serves as a source of the cascode GaN power device. As only one resistor is added on a cascode structure of the GaN device and Si MOS transistor, the structure of the GaN power device is simple. In addition, due to the presence of the resistor, turn-on time of the GaN device can be slowed down, so that the EMI characteristics can be improved.

### BRIEF DESCRIPTION OF THE DRAWINGS

To describe the technical solutions in embodiments of the present invention or in the conventional art more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG. 1 is a diagram of a corresponding circuit structure of a common-source common-gate structure.
FIG. 2 is a diagram of a corresponding circuit structure of a cascode GaN power device.
FIG. 3 is a top view of a GaN device.
FIG. 4 is a top view of a GaN device with a dashed line *a* as a cutting line.
FIG. 5 is a diagram of a corresponding cross-section of a GaN device after being cut along a dashed line *a.*
FIG. 6 is a top view of a GaN device with a dashed line b as a cutting line.
FIG. 7 is a diagram of a corresponding cross-section of a GaN device after being cut along a dashed line *b*.
FIG. 8 is a top view of a GaN device with a dashed line *c* as a cutting line.
FIG. 9 is a diagram of a corresponding cross-section of a GaN device after being cut along a dashed line *c*.

Reference numerals are as follows: 1-GaN device; 2-Si MOS transistor; G1-gate of Si MOS transistor; S1-source of Si MOS transistor; D1-drain of Si MOS transistor; G2-gate of GaN device; S2-source of GaN device; D2-drain of GaN device; and R-resistor.

### DETAILED DESCRIPTION OF THE EMBODIMENTS

The following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

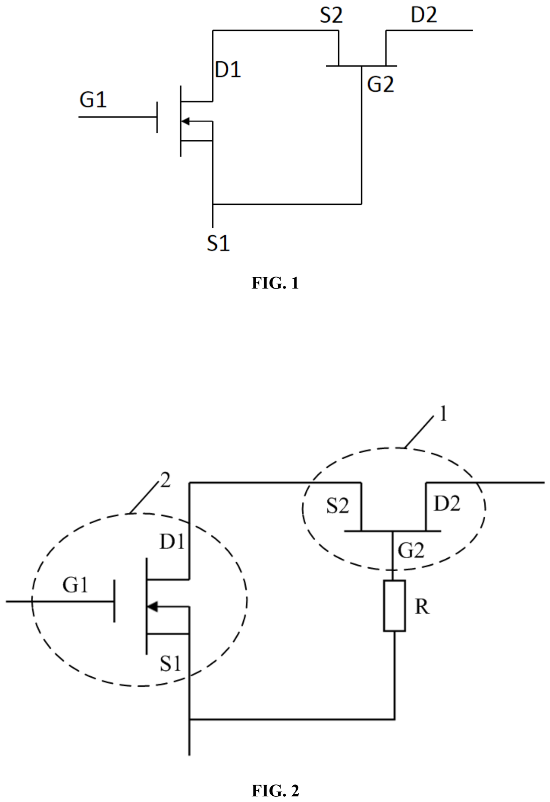

In practical application, the cascode power device controls the switching of a depletion-mode GaN device by using an Si MOS transistor to achieve an enhancement mode. In this cascode structure, a source of the Si MOS transistor is connected to a gate of the depletion-mode GaN device, and a drain of the Si MOS transistor is connected to a source of the depletion-mode GaN device, so that the cascode structure is also called a common-source common-gate structure, as shown in FIG. 1. As the switching of the GaN device is constrained by the turn-on of the Si MOS transistor, making it difficult to control its turn-on time and turn-off time, and resulting in poor EMI characteristics.

To improve the EMI characteristics, it is necessary to slow down a turn-on speed of the GaN device. Based on this, the present invention provides a novel cascode GaN power device. In a fabrication process of the device, one resistor is connected to the gate of the depletion-mode GaN device in series by using an AlGaN/GaN heterojunction. When cascoded with the Si MOS transistor, the gate of the depletion-mode GaN device is cascoded with the source of the Si MOS transistor through the series resistor. Due to the presence of the resistor, the turn-on time of the GaN device is slowed down, and the EMI characteristics are improved. Compared with other EMI improvement cascode devices, GaN power device provided by the present invention has a simpler structure and can be implemented by only one resistor, and there is no need to add other elements. Therefore, the area utilization of subsequent GaN chips is higher, and higher mass production value is achieved. The GaN chip is obtained by integrating the GaN device, the Si MOS transistor and the resistor.

To make the foregoing objectives, features and advantages of the present invention more apparent and easier to understand, the present invention is further described in detail with the accompanying drawings and specific embodiments.

As shown in FIG. 2, an embodiment of the present invention provides a cascode GaN power device, including a GaN device 1, an Si MOS transistor 2, and a resistor R.

A source S2 of the GaN device is connected to a drain D1 of the Si MOS transistor, a gate G2 of the GaN device is connected to a terminal of the resistor R, and the other terminal of the resistor R is connected to a source S1 of the Si MOS transistor. A drain D2 of the GaN device serves as a drain of the cascode GaN power device, a gate G1 of the Si MOS transistor serves as a gate of the cascode GaN power device, and the source S1 of the Si MOS transistor serves as a source of the cascode GaN power device.

The GaN device includes a substrate, a source, a gate, a drain, a passivation layer, and an epitaxial structure. The epitaxial structure includes a GaN buffer layer, a GaN channel layer, and an AlGaN barrier layer epitaxially grown sequentially from bottom to top on the substrate. The epitaxial structure is formed by carrying out epitaxial growth in a MOCVD equipment.

An end of the passivation layer is provided with a source groove, which extends downward from a top surface at the end of the passivation layer into the GaN channel layer, and the source is arranged in the source groove and connected to a two-dimensional free electron gas (i.e., two-dimensional electron gas) formed inside the GaN channel layer.

The other end of the passivation layer is provided with a drain groove, which extends downward from a top surface at the other end of the passivation layer into the GaN channel layer, and the drain is arranged in the drain groove and connected to the two-dimensional free electron gas formed inside the GaN channel layer.

The gate is arranged on a top surface of the passivation layer, close to a position of the source, and spaced from the source.

The source, the gate and the drain are all fabricated by using a semiconductor process. The semiconductor process includes lithography, sputtering, and etching.

In an embodiment, the GaN device 1 is a depletion-mode GaN device. The passivation layer is formed by depositing SiO₂, SiN or Al₂O₃ by employing a PECVD, LPCVD, or ALD method. The resistor is composed of the two-dimensional free electron gas formed inside the GaN channel layer. A resistance value of the resistor is 8 ohms.

In an embodiment, the cascode GaN power device further includes a resistor electrode.

The resistor electrode is arranged on the GaN device 1, the resistor R is connected to the resistor electrode, and the resistor electrode is connected to the source S1 of the Si MOS transistor.

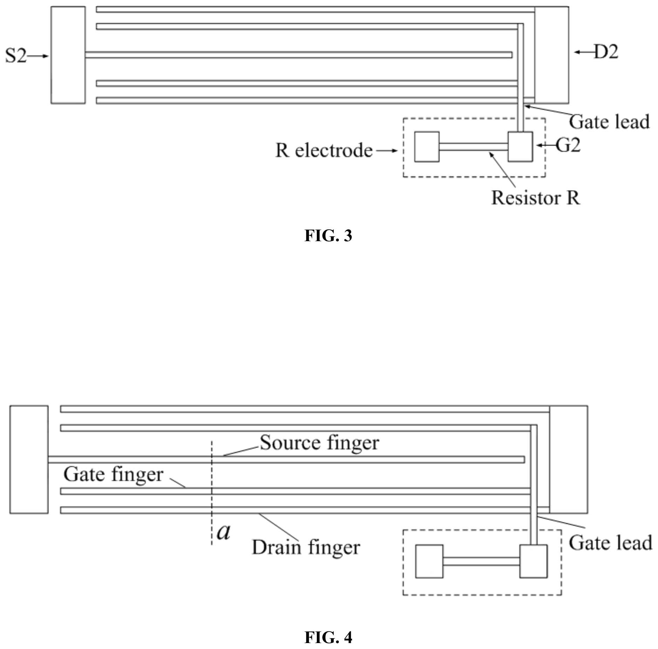

FIG. 3 is a top view of a GaN device in the present invention, a gate G2 of the GaN device is connected to a gate finger on a GaN chip through a gate lead. The resistor R is the resistor formed by the two-dimensional electron gas below AlGaN/GaN, that is, the AlGaN barrier layer and the GaN channel layer. The resistor electrode (R electrode) is also fabricated on the GaN device, and when subsequentially cascoded with the Si MOS transistor, the R electrode is directly connected to the source of the Si MOS transistor. A region circled by a dashed box in FIG. 3 is a region where the resistor is located. As the resistor R is composed of the two-dimensional electron gas formed by the heterojunction of the AlGaN barrier layer and the GaN channel layer, the three regions (i.e., the resistor R, the R electrode and the gate G2 of the GaN device) are non-implantation regions, and other regions in the dashed box are implantation regions except these three regions. An implantation region refers to a region where the two-dimensional electron gas below the AlGaN barrier layer is destroyed by ion implantation, thereby changing the region into an insulating region.

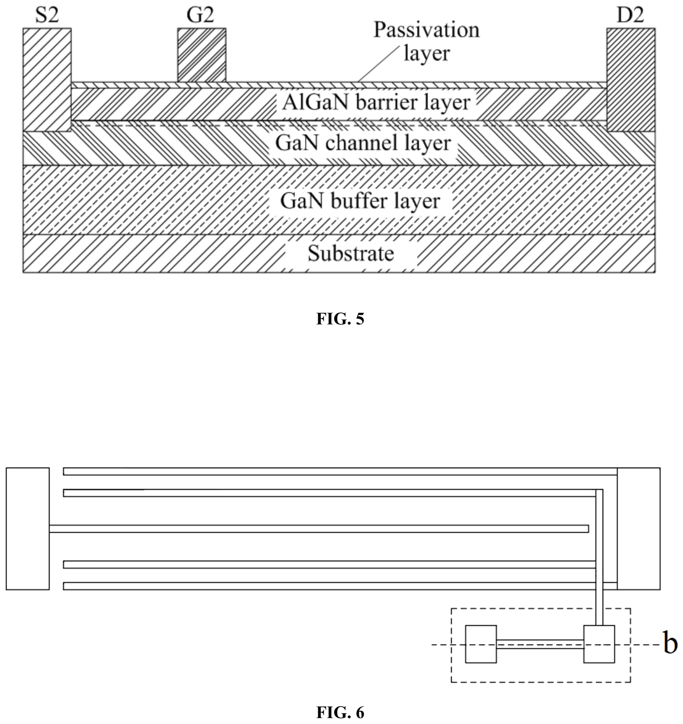

To further describe a structure of the GaN device of the present invention, the top view and cross-sectional diagram of each region of the GaN device are analyzed. FIG. 4 is a top view with a dashed line *a* as a cutting line, when the dashed line *a* is the cutting line, a source finger, a gate finger and a drain finger corresponding to the GaN device in the GaN chip are cut. FIG. 5 is a cross-sectional diagram corresponding to the dashed line *a*, including a substrate, a GaN buffer layer, a GaN channel layer and an AlGaN barrier layer in turn from bottom to top.

The formation steps of these structures are as follows: the substrate is put into a metal-organic chemical vapor deposition (MOCVD) equipment, and the GaN buffer layer, the GaN channel layer and the AlGaN barrier layer are epitaxially grown on the substrate in sequence to form the epitaxial structure. A passivation layer (in which a deposition material may be SiO₂, SiN, Al₂O₃, and the like) is deposited on the AlGaN barrier layer, in which the deposition method may be plasma enhance chemical vapor deposition (PECVD), low pressure chemical vapor deposition (LPCVD), atomic layer deposition (ALD), and the like. The source, gate and drain are fabricated by using semiconductor processes such as lithography, sputtering and etching.

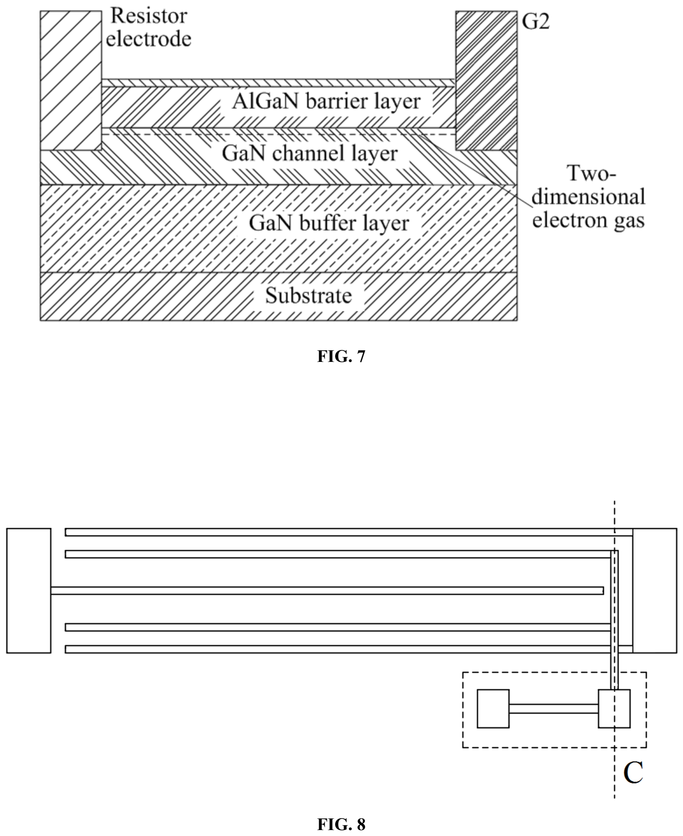

FIG. 6 is a top view of a GaN device with a dashed line *b* as a cutting line. The dashed line *b* is a cutting line along the R electrode, the resistor R and the gate G2 of the GaN device; and FIG. 7 is a diagram of a cross-section obtained by cutting along a dashed line *b*. The resistor R is conductive by means of the two-dimensional electron gas (shown by the dashed line in FIG.7), and the resistor R is connected to the R electrode and the gate G2 of the GaN device. When cascoded with the Si MOS transistor, the source of the Si MOS transistor is connected to the R electrode.

For the selection of the resistor R, a recommended resistance value ranges from 3 to 20 ohms, and a typical resistance value is 8 ohms. If the resistance value is too small, it has little influence on the turn-on time, and the turn-on is still fast, and the EMI performance is relatively poor. If the resistance value is too large, during turn-off, a large stress is formed in the Si MOS transistor due to RC delay, leading to the avalanche of the Si MOS transistor.

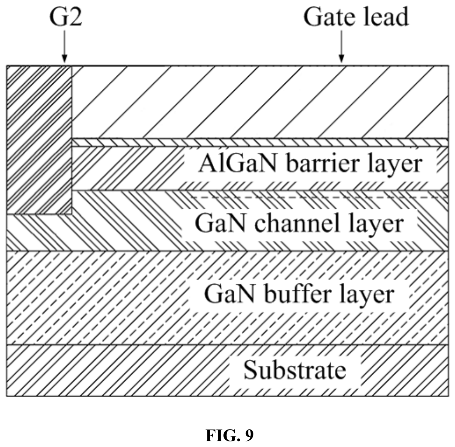

FIG. 8 is a top view of a GaN device with a dashed line c as a cutting line, and the dashed line c is a cutting line cut along the gate G2 of the GaN device and the gate lead. FIG. 9 is a diagram of a corresponding cross-section of a GaN device cut along a dashed line *c*. The gate G2 of the GaN device is connected to the gate finger through the gate lead.

Various technical features of the foregoing embodiments can be combined arbitrarily. For the sake of brevity, not all possible combinations of the technical features in the foregoing embodiments are described. However, the combinations of these technical features should be considered to be within the scope of this specification as long as there is no contradiction therebetween.

Several examples are used for illustration of the principles and implementations of the present invention. The description of the embodiments is merely used to help illustrate the method and its core principles of the present invention. In addition, a person of ordinary skill in the art can make various modifications in terms of specific implementations and scope of application in accordance with the teachings of the present invention. In conclusion, the content of this specification shall not be construed as a limitation to the present invention.

## Claims

1. A cascode GaN power device, comprising a GaN device, an Si Metal Oxide Semiconductor (MOS) transistor, and a resistor, wherein
a source of the GaN device is connected to a drain of the Si MOS transistor, a gate of the GaN device is connected to a terminal of the resistor, and another terminal of the resistor is connected to a source of the Si MOS transistor; and a drain of the GaN device serves as a drain of the cascode GaN power device, a gate of the Si MOS transistor serves as a gate of the cascode GaN power device, and the source of the Si MOS transistor serves as a source of the cascode GaN power device.

2. The cascode GaN power device according to claim 1, wherein the GaN device comprises a substrate, the source, the gate, the drain, a passivation layer, and an epitaxial structure; and the epitaxial structure comprises a GaN buffer layer, a GaN channel layer and an AlGaN barrier layer epitaxially grown sequentially from bottom to top on the substrate;
an end of the passivation layer is provided with a source groove, wherein the source groove extends downward from a top surface at the end of the passivation layer into the GaN channel layer, and the source is arranged in the source groove and connected to a two-dimensional free electron gas formed inside the GaN channel layer;
another end of the passivation layer is provided with a drain groove, wherein the drain groove extends downward from a top surface at the another end of the passivation layer into the GaN channel layer, and the drain is arranged in the drain groove and connected to the two-dimensional free electron gas formed inside the GaN channel layer; and
the gate is arranged on the top surface of the passivation layer, close to the source, and spaced from the source.

3. The cascode GaN power device according to claim 1, wherein the GaN device is a depletion-mode GaN device.

4. The cascode GaN power device according to claim 2, wherein the passivation layer is formed by depositing SiO₂, SiN or Al₂O₃ by employing a Plasma Enhance Chemical Vapor Deposition (PECVD), Low Pressure Chemical Vapor Deposition (LPCVD), or Atomic Layer Deposition (ALD) method.

5. The cascode GaN power device according to claim 2, wherein the resistor is composed of the two-dimensional free electron gas formed inside the GaN channel layer.

6. The cascode GaN power device according to claim 1, wherein a resistance value of the resistor is 8 ohms.

7. The cascode GaN power device according to claim 1, further comprising a resistor electrode, wherein
the resistor electrode is arranged on the GaN device, the resistor is connected to the resistor electrode, and the resistor electrode is connected to the source of the Si MOS transistor.

8. The cascode GaN power device according to claim 2, wherein the source, the gate and the drain are all fabricated by using a semiconductor process.

9. The cascode GaN power device according to claim 8, wherein the semiconductor process comprises lithography, sputtering, and etching.

10. The cascode GaN power device according to claim 2, wherein the epitaxial structure is formed by carrying out epitaxial growth in a Metal-organic Chemical Vapor Deposition (MOCVD) equipment.
